# EUROPÄISCHE PATENTSCHRIFT

(11) **EP 1 106 913 B1**
(45) Veröffentlichungstag und Bekanntmachung des Hinweises auf die Patenterteilung: **25.05.2005**
(21) Anmeldenummer: 00103764.7
(22) Anmeldetag: 23.02.2000
(51) Int. Cl.: F21V 8/00

(54) **Leiterplattenmontierbares Anzeigeelement**
Circuit boards surface mountable display element
Dispositif d'affichage attachable à la surface des plaquettes de circuits

(30) Priorität: 08.12.1999 EP 99124495
(43) Veröffentlichungstag der Anmeldung: 13.06.2001
(73) Patentinhaber: MENTOR GMBH & CO., D-40699 Erkrath (DE)
(72) Erfinder: Kroening, Gerald, 42781 Haan (DE)
(74) Vertreter: Sparing - Röhl - Henseler Patentanwälte

(56) Entgegenhaltungen:
- EP-A- 0 403 764
- EP-A- 0 421 824
- EP-A- 0 751 340

## Beschreibung

Die Erfindung betrifft ein leiterplattenmontierbares Anzeigeelement nach dem Oberbegriff des Anspruchs 1.

Aus EP-B-0 421 824 ist ein derartiges Anzeigeelement bekannt, das dazu dient, auf gedruckten Leiterplatten durch SMD-Technik angebracht zu werden und ein Gehäuse umfaßt, das eine T-förmige Öffnung aufweist. Die T-förmige Öffnung nimmt dabei an dem der Leiterplatte zugewandten Ende eine LED (Licht emittierende Diode) auf, während ein anderes Ende eine aus dem Gehäuse herausragende Linse aufnimmt, die gegenüber von der LED eine Schrägfläche aufweist, benachbart zu der eine Kunststoffmasse vom dritten Ende der T-förmigen Öffnung in diese eingefüllt ist. Hierdurch wird eine von der LED einfallendes Licht zum Austrittsende der Linse reflektierende Innenfläche gebildet. Die LED bildet hierbei die Basis des Anzeigeelements und dient zu dessen Befestigung auf einer Leiterplatte. Ein derartiges Anzeigeelement besitzt einen relativ komplizierten Aufbau, zumal es drei Einzelteile und die Kunststoffmasse umfaßt, die zu dem Anzeigeelement zusammenzusetzen sind.

Aufgabe der Erfindung ist es, ein Anzeigeelement nach dem Oberbegriff des Anspruchs 1 zu schaffen, das eine wesentlich vereinfachte Herstellung ermöglicht.

Diese Aufgabe wird entsprechend dem kennzeichnenden Teil des Anspruchs 1 gelöst.

Dadurch, daß als Anzeigeelement ein Lichtleiter verwendet wird, der die LED aufnimmt und die Lichtaustritts- und damit die Anzeigefläche bildet, benötigt man für das Anzeigeelement nur zwei einfach miteinander zu verbindende Bauteile und benötigt kein separates Gehäuse, in das verschiedene Teile einsetzbar und eine Kunststoffmasse einfügbar ist. Hierdurch wird die Herstellung erheblich vereinfacht, und zwar unabhängig von der Art der verwendeten LED bzw. der gewünschten Anbringung an einer Leiterplatte, d.h. daß auch andere Techniken als die SMD-Technik verwendbar sind.

Weitere Ausgestaltungen der Erfindung sind der nachfolgenden Beschreibung und den Unteransprüchen zu entnehmen.

Die Erfindung wird nachstehend anhand von in den beigefügten Abbildungen schematisiert dargestellten Ausführungsbeispielen näher erläutert.
Fig. 1 zeigt eine Seitenansicht eines Anzeigeelements.
Fig. 2 zeigt eine Draufsicht auf das Anzeigeelement von Fig. 1.
Fig. 3 bis 5 zeigen weitere Ausführungsformen eines Anzeigeelements in Seitenansicht.
Fig. 6 und 7 zeigen Frontansichten weiterer Ausführungsformen.
Fig. 8 zeigt eine Ausführungsform von übereinander angeordneten Anzeigeelementen in Seitenansicht.
Fig. 9 zeigt eine Variante der Ausführungsform von Fig. 8 in Frontansicht.
Fig. 10 und 11 zeigen weitere Ausführungsformen von übereinander angeordneten Anzeigeelementen in Seitenansicht bzw. im Schnitt.
Fig. 12 und 13 zeigen zwei Ausführungsformen von miteinander kombinierten Anzeigeelementen in Seitenansicht.
Fig. 14 und 15 zeigen zwei Ausführungsformen von stehend auf einer Leiterkarte angeordneten Anzeigeelementen.

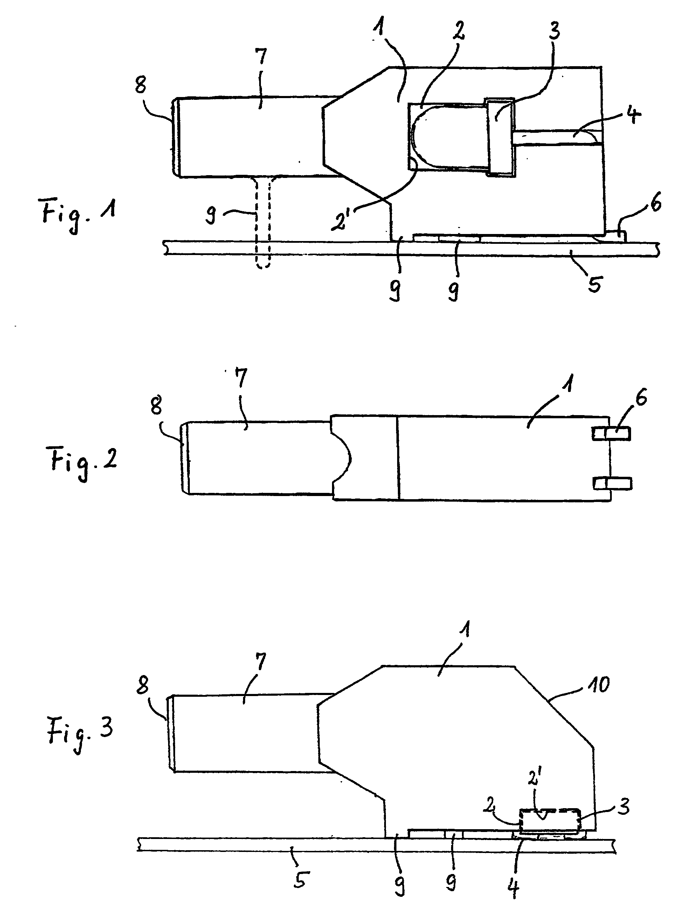

Das in Fig. 1 und 2 dargestellte Anzeigeelement umfaßt einen Lichtleiter 1, der über eine entsprechende seitliche Öffnung 2 eingesetzt eine LED 3 aufnimmt, deren Anschlußdrähte 4 durch zweimaliges Biegen aus dem Lichtleiter 1 herausgeführt sind und mittels SMD-Technik auf eine Leiterplatte 5 auflötbare Füße 6 besitzen. Durch die gebogenen Anschlußdrähte 4 wird die LED 3 in dem Lichtleiter 1 gehalten. Die Öffnung 2 bildet eine Lichteinkoppelfläche 2' für von der LED 3 emittiertes Licht.

Der ansonsten im wesentlichen quaderförmige Lichtleiter 1 besitzt frontseitig einen im wesentlichen zylindrischen Fortsatz 7 mit einer frontseitigen, planen oder runden Lichtaustrittsfläche 8, wobei die Öffnung 2 mit der LED 3 vorzugsweise im wesentlichen in der Achse des zylindrischen Fortsatzes 7 angeordnet ist. Von der LED 3 emittiertes Licht wird somit relativ geradlinig zur Lichtaustrittsfläche 8 geführt, da sich Lichtaustrittsfläche 8 und Lichteinkoppelfläche 2' im wesentlichen gegenüber liegen.

Der Fortsatz 7 kann hier ebenso wie bei den anderen Ausführungsformen unterschiedlich in seiner Länge, seinem Querschnitt und der Gestalt der Lichtaustrittsfläche 8 gestaltet sein, wobei hierfür zweckmäßigerweise bei der Herstellung des Lichtleiters 1 durch Spritzgießen ein Wechseleinsatz im Werkzeug verwendet wird. Hierdurch läßt sich das Anzeigeelement an unterschiedliche Einbauverhältnisse und Benutzerwünsche anpassen.

Generell können der Lichtleiter 1 und gegebenenfalls sein Fortsatz 7 Abstützelemente 9 aufweisen, die sich auf der Leiterplatte 5 abstützen bzw. befestigt sind oder in entsprechende Bohrungen in der Leiterplatte 5 eingesteckt sind.

Die Anschlußdrähte 4 können auch zum Durchstecken durch entsprechende Bohrungen der Leiterplatte 5 ausgebildet sein.

Bei der in Fig. 3 dargestellten Ausführungsform ist eine nach oben abstrahlende LED 3 vorgesehen, die in eine entsprechende, von der Bodenseite des Lichtleiters 1 her zugängliche Ausnehmung des im wesentlichen quaderförmigen und mit einem frontseitigen Fortsatz 7 versehenen Lichtleiters 1 eingeklebt oder anders befestigt sein kann. Gegenüber von der LED 3 ist der Lichtleiter 1 mit einer (insbesondere 45°) schrägen Reflektionsfläche 10 versehen, die von der LED 3 emittiertes Licht in den Fortsatz 7 zu dessen Lichtaustrittsfläche 8 reflektiert. - Auch hier können Abstützelemente 9 vorgesehen sein, während die LED 3 über entsprechende Anschüsse 4 mit der Leiterplatte 5 mittels SMD-Technik verbindbar ist.

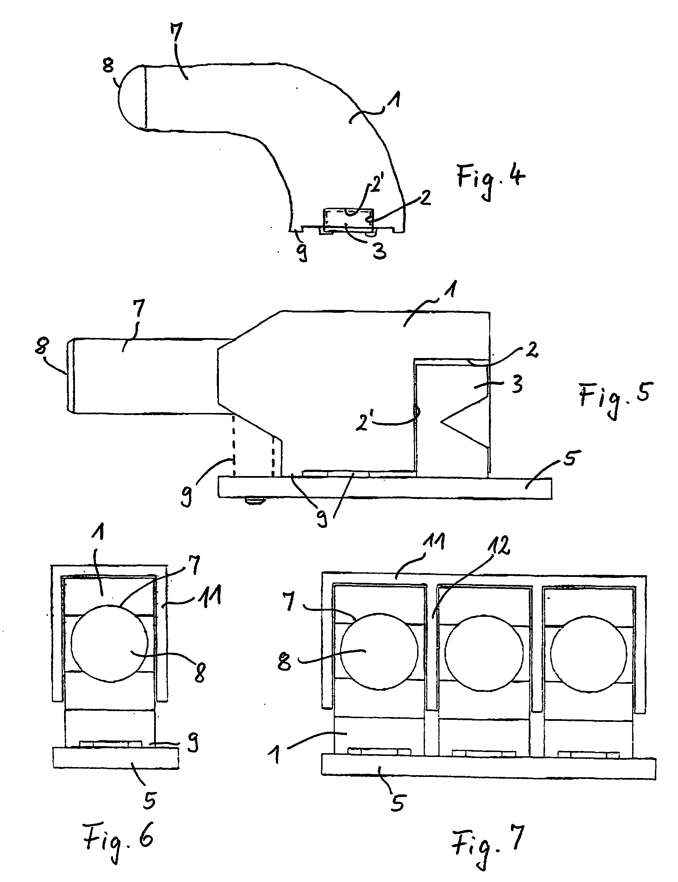

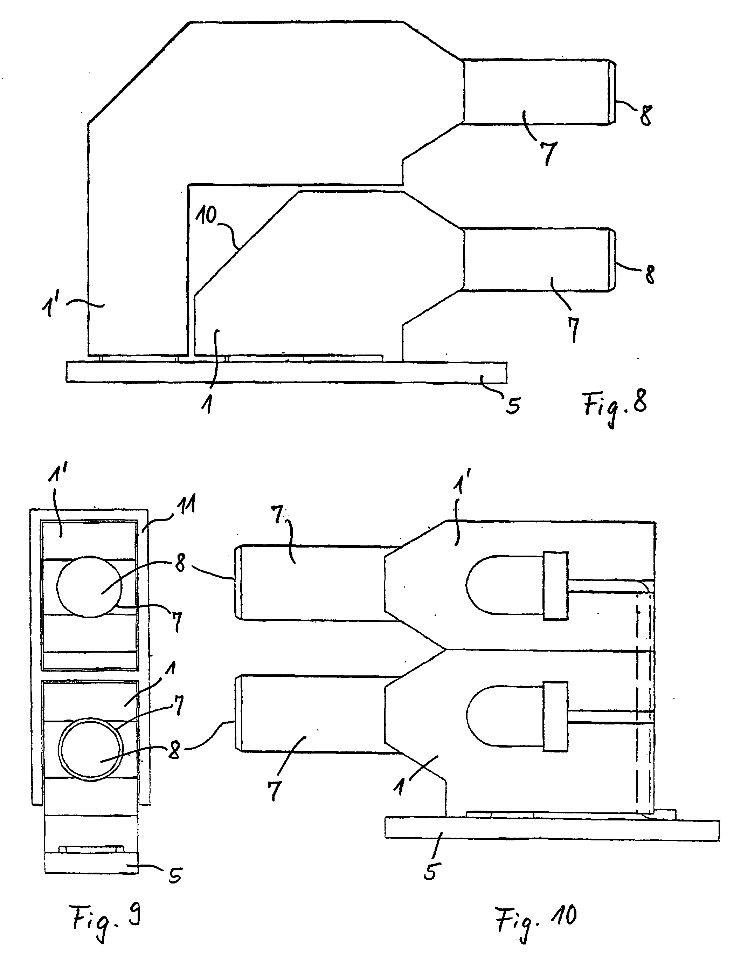

Bei der in Fig. 4 dargestellten Ausführungsform besitzt der Lichtleiter 1 eine Krümmung, die Reflexion des von der LED 3 in den Lichtleiter 1 emitierten Lichts an seiner Innenwandung bis zur Lichtaustrittsfläche 8 sicherstellt. Hierbei stützt sich der Lichtleiter 1 mit einem fußartigen Abstützelement 9 auf der Leiterplatte 5 ab.

Bei der in Fig. 5 dargestellten Ausführungsform ist eine seitlich abstrahlende LED 3 in der Ausnehmung 2, die von der Boden- und Rückseite des Lichtleiters 1 zugänglich ist, vorgesehen und beispielsweise durch Einkleben befestigt. Obwohl die LED 3 in diesem Ausführungsbeispiel nicht in bezug auf den Fortsatz 7 genauer ausgerichtet ist, gelangt in diesen bei eingeschalteter LED 3 genügend Licht, um eine Anzeige bewirken zu können. Hierbei stützt sich der Lichtleiter 1 auch mit einem fußartigen Abstützelement 9 auf der Leiterplatte 5 ab, das in diese eingesteckt ist, wie dies auch bei den anderen Ausführungsformen der Fall sein kann.

Wie in Fig. 6 dargestellt ist, kann auf dem Lichtleiter 1 eine relativ dünnwandige, U-förmige Blende 11 aus lichtundurchlässigem Material angeordnet sein, um das Austreten von Streulicht zu vermeiden, wenn dadurch benachbarte Anzeigeelemente beeinträchtigt werden sollten. Wenn mehrere Anzeigeelemente nebeneinander angeordnet werden, kann eine kammartige, sich über und zwischen die Anzeigeelemente erstreckende Blende 11 vorgesehen sein, vgl. Fig. 7. Stege 12 der Blende 11 zwischen den Anzeigeelementen können hierbei eine Breite oder Ausformung entsprechend dem Rasterabstand der Anzeigeelemente aufweisen. Die Blende 11 kann beispielsweise mittels Klemmsitz auf dem oder den Anzeigeelemente sitzen oder darauf aufgeclipst oder damit verrastet oder damit verklebt sein, so daß hierdurch ein Bauteil aus mehreren Anzeigeelementen gebildet wird.

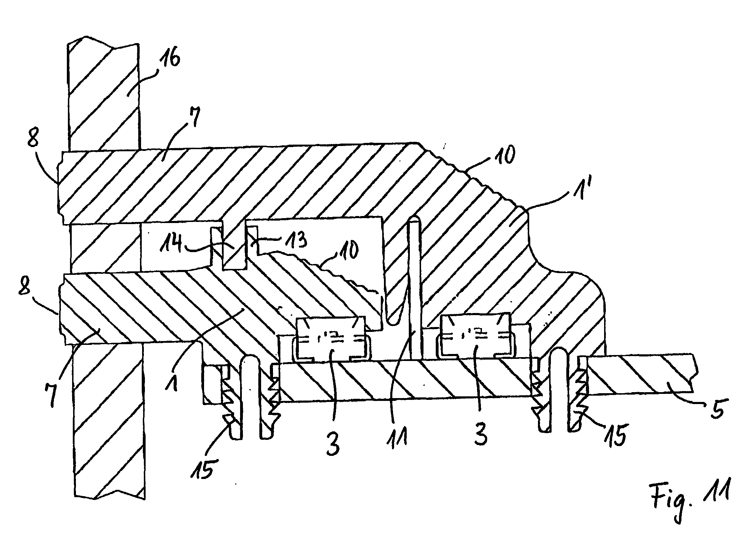

Wie aus Fig. 8 ersichtlich, können auch mehrere Anzeigeelemente mit nach oben abstrahlenden LED's 3 übereinander angeordnet werden, wobei der Lichtleiter 1' des überbauenden Anzeigeelements im wesentlichen L-förmig ist und ebenfalls einen entsprechenden Fortsatz 7 trägt. Zwischen diesen Anzeigeelementen kann ebenfalls eine Blende 11 angeordnet sein, Fig. 9, die die Anzeigeelemente miteinander verbindet.

Bei Verwendung von bedrahteten LED's 3 können die Lichtleiter 1 auch übereinander angeordnet und die Anschlußdrähte 4 entsprechend gebogen werden, so daß sich ihre Füße 6 in der gleichen Ebene zum Anschluß an eine Leiterplatte 5 befinden, vgl. Fig. 10.

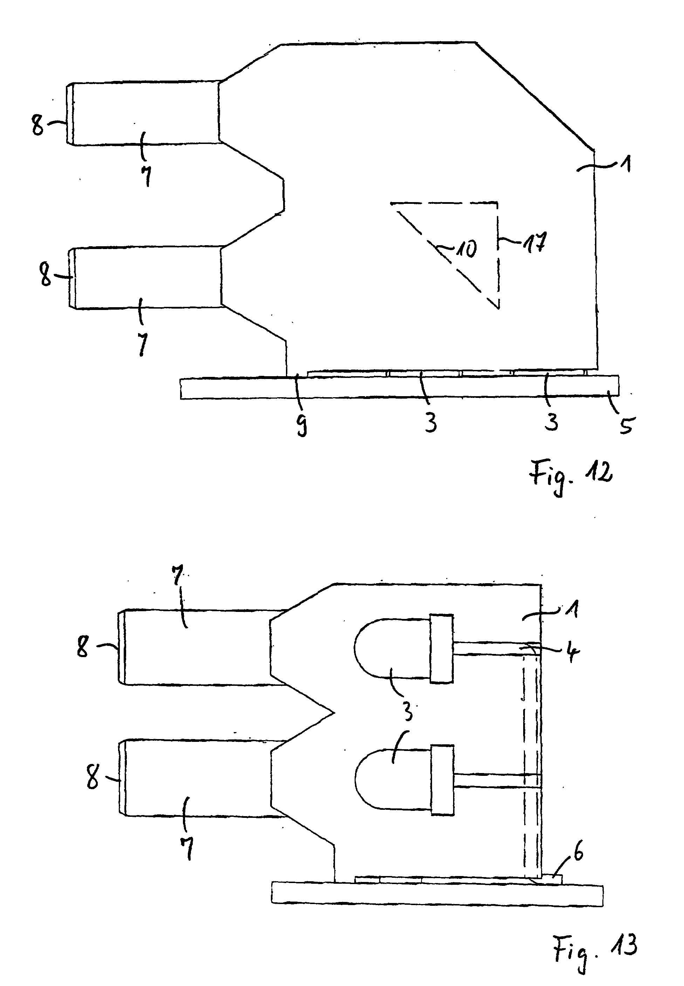

Bei der in Fig. 11 im Schnitt dargestellten Ausführungsform sind zwei Anzeigeelemente übereinander angeordnet, wobei das untere, benachbart zum Rand der Leiterplatte 5 angeordnete im wesentlichen entsprechend Fig. 3 ausgebildet ist und im Bereich des Lichtleiters 1 benachbart zu seinem Fortsatz 7 ein Steckverbindungselement 13 aufweist, das mit einem korrespondierenden Steckverbindungselement 14 am Fortsatz 7 des darüber befindlichen, L-förmigen Lichtleiters 1' in Eingriff steht. Außerdem sind hier beide Lichtleiter 1, 1' unterseitig mit geschlitzten und außenseitig geriffelten Einsteckfüßen 15 zum Einstecken in entsprechende Öffnungen der Leiterkarte 5 versehen. Die Fortsätze 7 stecken mit ihren freien Endbereichen in entsprechenden Öffnungen einer senkrecht zur Leiterplatte 5 angeordneten Frontplatte 16. Der Einsteckfuß 15 des unteren Lichtleiters 1 ist dabei im Bereich benachbart zum Fortsatz 7 angeordnet, während der Einsteckfuß des oberen Lichtleiters 1' an der dem Fortsatz abgewandten Seite des Lichtleiters 1' angeordnet ist.

Bei der in Fig. 11 dargestellten Ausführungsform ist in dem Lichtleiter 1 benachbart zum Lichtleiter 1 ein Schlitz angeordnet, in den eine Blende 11 eingesteckt ist, um den Übertritt von Streulicht von einem Lichtleiter zum anderen im wesentlichen zu vermeiden.

Gemäß Fig. 12 ist ein einstückiger Lichtleiter 1 mit mehreren Fortsätzen 7 und damit mehreren Lichtaustrittsflächen 8, denen jeweils eine LED 3 zugeordnet ist, vorgesehen. Im dargestellten Ausführungsbeispiel sind zwei Lichtaustrittsflächen 8 (mit zwei zugehörigen LED's 3) übereinander vorgesehen, jedoch können auch mehr als zwei vorgesehen sein, und zwar über- als auch nebeneinander. Gegebenenfalls kann ein eine Reflexionsfläche 10 liefernder Ausschnitt 17 im Lichtleiter 1 vorgesehen sein.

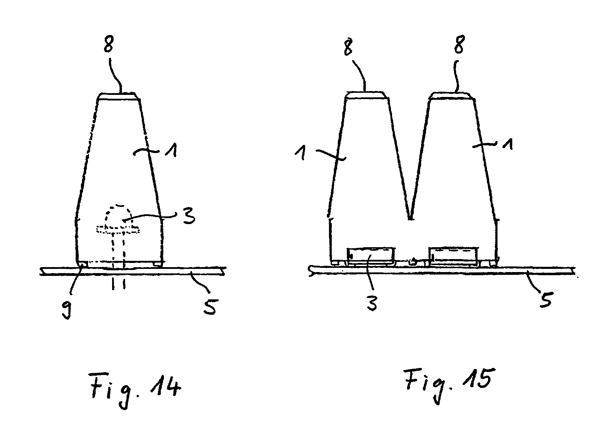

Bei der In Fig. 13 dargestellten Ausführungsform ist eine Fig. 12 entsprechende Ausführungsform mit bedrahteten LED's 3 dargestellt.

Bei parallel zur Leiterplatte 5 verlaufender Frontplatte 16 kann die wenigstens eine Lichtaustrittsfläche 8 des Lichtleiters 1 auch über der LED 3 angeordnet sein. Derartige Ausführungsformen sind in den Fig. 14 und 15 in Einfach- und kombinierter Mehrfachanordnung dargestellt. Die jeweiligen Lichtleiter 1 laufen bei diesen Ausführungsformen sich verjüngend, insbesondere konisch zur Lichtaustrittsfläche 8 zu. Bei diesen Ausführungsformen erübrigt sich eine Umlenkung des Lichts.

Anstelle eine Blende 11 können auch die entsprechenden Wandungen des Lichtleiters 1, die störendes Streulicht abgeben könnten, durch eine entsprechende Schicht, die etwa durch Bedrucken, Umspritzen oder durch anderweitiges Beschichten mittels eines Lacks od.dgl. hergestellt wird, lichtundurchlässig gemacht sein.

Der Lichtleiter 1 kann entsprechend farbig sein, um unterschiedliche Farben der Lichtaustrittsflächen 8 vorsehen zu können. Das Licht, das von der jeweiligen LED 3 abgestrahlt wird, braucht nicht weiß zu sein, sondern kann auch farbig sein, wobei die Farbintensität gegebenenfalls durch die Wahl der Einfärbung des Lichtleiters 1 verstärkt werden kann.

Die Abstützelemente 9 können einstückig mit dem Lichtleiter 1 ausgebildet oder an diesem befestigt sein. Sie können je nach Bedarf durch die Leiterplatte 5 hindurchführen, auf dieser geeignet befestigt werden oder sich nur auf dieser abstützen, um einen guten Stand des Anzeigeelements auf der Leiterplatte 5 sowie gegebenenfalls eine zusätzliche Fixierung zu gewährleisten.

Die jeweils verwendete LED 3 kann zwei oder mehr elektrische Anschlüsse 4 aufweisen, die für die jeweilige Befestigungstechnik an der Leiterplatte 5 geeignet sind.

Dadurch, daß Lichtleiter und LED eine Baueinheit bilden, erübrigt sich ein nachträgliches Aufsetzen und Befestigen des Lichtleiters auf der Leiterplatte. Dies spart nicht nur Montagearbeit, sondern führt auch zu einem verringerten Platzbedarf auf der Leiterplatte.

## Patentansprüche

1. Leiterplattenmontierbares Anzeigeelement mit mindestens einer LED (3) und einer Einrichtung zum Ausleuchten einer sich im wesentlichen senkrecht zur Lichtausbreitungsrichtung erstreckenden Lichtaustrittsfläche (8), **dadurch gekennzeichnet, daß** es aus einem die Einrichtung zum Ausleuchten und die Lichtaustrittsfläche (8) bildenden Lichtleiter (1) besteht, der eine Ausnehmung (2) aufweist, die eine Lichteinkoppelfläche (2') für Licht von der LED (3) aufweist und in der die LED (3) befestigt ist, und der wenigstens ein Stützelement (9) zum Abstützen auf einer Leiterplatte (5) aufweist, wobei die Anschlußdrähte (4) der LED (3) mittels SMD-Technik auf die Leiterplatte (5) auflötbare Füße (6) besitzen.

2. Anzeigeelement nach Anspruch 1, **dadurch gekennzeichnet, daß** der Lichtleiter (1) im wesentlichen quaderförmig ist.

3. Anzeigeelement nach Anspruch 1 oder 2, **dadurch gekennzeichnet, daß** der Lichtleiter (1) einen frontseitigen, die Lichtaustrittsfläche (8) bildenden Fortsatz (7) aufweist.

4. Anzeigeelement nach Anspruch 3, **dadurch gekennzeichnet, daß** der Fortsatz zylindrisch oder prismatisch ist.

5. Anzeigeelement nach einem der Ansprüche 1 bis 4, **dadurch gekennzeichnet, daß** die Lichteinkoppelfläche (2') im wesentlichen gegenüber der Lichtaustrittsfläche (8) angeordnet ist.

6. Anzeigeelement nach einem der Ansprüche 1 bis 5, **dadurch gekennzeichnet, daß** die LED (3) Anschlußdrähte (4) aufweist, die gebogen aus der die LED (3) aufnehmenden Ausnehmung (2) herausgeführt sind.

7. Anzeigeelement nach einem der Ansprüche 1 bis 4, **dadurch gekennzeichnet, daß** die LED (3) eine oberseitig lichtabstrahlende LED ist.

8. Anzeigeelement nach Anspruch 7, **dadurch gekennzeichnet, daß** der Lichtleiter (1) eine der LED (3) gegenüberliegende, zumindest im wesentlichen schräge Reflexionsfläche (10) aufweist.

9. Anzeigeelement nach einem der Ansprüche 3, 4 oder 6 bis 8, **dadurch gekennzeichnet, daß** der Lichtleiter (1) eine von der Lichteinkoppelfläche (2') zur Lichtaustrittsfläche (8) reflektierende Krümmung aufweist.

10. Anzeigeelement nach einem der Ansprüche 3, 4 oder 6 bis 8, **dadurch gekennzeichnet, daß** der Lichtleiter (1') im wesentlichen L-förmig und wenigstens einen weiteren Lichtleiter (1) im wesentlichen in Quaderform überbauend ausgebildet ist.

11. Anzeigeelement nach einem der Ansprüche 1 bis 5, **dadurch gekennzeichnet, daß** die LED (3) eine seitlich abstrahlende LED ist, die in einer boden- und gegebenenfalls rückseitig offenen Ausnehmung (2) des Lichtleiters (1) angeordnet ist.

12. Anzeigeelement nach einem der Ansprüche 1 bis 9 oder 11, **dadurch gekennzeichnet, daß** der Lichtleiter (1) mindestens zwei Lichtaustrittsflächen (8) mit entsprechend zugeordneten LED's (3) aufweist.

13. Anzeigeelement nach einem der Ansprüche 1 bis 12, **dadurch gekennzeichnet, daß** das Stützelement (9) in die Leiterplatte (5) einsteckbar und/oder auf diese aufsetzbar ist.

14. Anzeigeelement nach einem der Ansprüche 1 bis 13, **dadurch gekennzeichnet, daß** das wenigstens eine Stützelement (9) einstückig mit dem Lichtleiter (1) ausgebildet ist.

15. Anzeigeelement nach einem der Ansprüche 1 bis 14, **dadurch gekennzeichnet, daß** eine den Lichtleiter (1) übergreifende Blende (11) vorgesehen ist.

16. Anzeigeelement nach Anspruch 15, **dadurch gekennzeichnet, daß** die Blende (11) kammartig mehrere Lichtleiter (1) übergreifend ausgebildet ist.

17. Anzeigeelement nach einem der Ansprüche 1 bis 16, **dadurch gekennzeichnet, daß** der Lichtleiter (1) wenigstens an einer störendes Streulicht abgebenden Fläche mit einer lichtundurchlässigen Beschichtung versehen ist.

18. Anzeigeelement nach einem der Ansprüche 1 bis 17, **dadurch gekennzeichnet, daß** der Lichtleiter (1) eingefärbt ist.

## Claims

1. Display element capable of being mounted on a printed circuit board, having at least one LED (3) and a device for illuminating a light exit area (8) extending essentially perpendicularly to the direction of light propagation, **characterized in that** it comprises an optical waveguide (1) forming the illuminating device and the light exit area (8), which optical waveguide has a recess (2), which has a light coupling-in area (2') for light from the LED (3) and in which the LED (3) is fixed, and which optical waveguide has at least one supporting element (9) for support on a printed circuit board (5), the connecting wires (4) of the LED (3) having feet (6) which can be soldered onto the printed circuit board (5) by means of SMD technology.

2. Display element according to Claim 1, **characterized in that** the optical waveguide (1) is essentially parallelepipedal.

3. Display element according to Claim 1 or 2, **characterized in that** the optical waveguide (1) has an extension (7) at the front, the said extension forming the light exit area (8).

4. Display element according to Claim 3, **characterized in that** the extension is cylindrical or prismatic.

5. Display element according to one of Claims 1 to 4, **characterized in that** the light coupling-in area (2') is arranged essentially opposite the light exit area (8).

6. Display element according to one of Claims 1 to 5, **characterized in that** the LED (3) has connecting wires (4) which are routed in bent fashion out of the recess (2) accommodating the LED (3).

7. Display element according to one of Claims 1 to 4, **characterized in that** the LED (3) is an LED emitting light at the top.

8. Display element according to Claim 7, **characterized in that** the optical waveguide (1) has an at least essentially slanted reflecting area (10) situated opposite the LED (3).

9. Display element according to one of Claims 3, 4 or 6 to 8, **characterized in that** the optical waveguide (1) has a reflective curvature from the light coupling-in area (2') to the light exit area (8).

10. Display element according to one of Claims 3, 4 or 6 to 8, **characterized in that** the optical waveguide (1') is essentially L-shaped and is constructed above at least one further optical waveguide (1) essentially in parallelepipedal form.

11. Display element according to one of Claims 1 to 5, **characterized in that** the LED (3) is a laterally emitting LED arranged in a recess (2) in the optical waveguide (1) which is open at the bottom and, if appropriate, at the rear side.

12. Display element according to one of Claims 1 to 9 or 11, **characterized in that** the optical waveguide (1) has at least two light exit areas (8) with correspondingly assigned LEDs (3).

13. Display element according to one of Claims 1 to 12, **characterized in that** the supporting element (9) can be plugged into the printed circuit board (5) and/or can be placed on top of the latter.

14. Display element according to one of Claims 1 to 13, **characterized in that** the at least one supporting element (9) is formed in one piece with the optical waveguide (1).

15. Display element according to one of Claims 1 to 14, **characterized in that** a screen (11) engaging over the optical waveguide (1) is provided.

16. Display element according to Claim 15, **characterized in that** the screen (11) is formed in a manner such that it engages over a plurality of optical waveguides (1) in a comb-like manner.

17. Display element according to one of Claims 1 to 16, **characterized in that** the optical waveguide (1) is provided with an opaque coating at least at an area which emits interfering scattered light.

18. Display element according to one of Claims 1 to 17, **characterized in that** the optical waveguide (1) is coloured.

## Revendications

1. Elément d'affichage pouvant être monté sur une carte imprimée, avec au moins une DEL (3) et un dispositif d'éclairage d'une surface de sortie de lumière (8) s'étendant sensiblement perpendiculairement à la direction de propagation de lumière, **caractérisé en ce qu'**il est constitué d'un conduit de lumière (1), formant le dispositif d'éclairage et la surface de sortie de lumière (8), qui comporte un creux (2) présentant une surface d'injection de lumière (2') pour la lumière de la DEL (3) et dans lequel est fixée la DEL (3), et qui présente au moins un élément d'appui (9) pour l'appui sur une carte imprimée (5), les fils de connexion (4) de la DEL (3) possédant des socles (6) pouvant être brasés sur la carte imprimée (5) au moyen de la technique SMD.

2. Elément d'affichage selon la revendication 1, **caractérisé en ce que** le conduit de lumière (1) est sensiblement en forme de parallélépipède rectangle.

3. Elément d'affichage selon la revendication 1 ou 2, **caractérisé en ce que** le conduit de lumière (1) présente un prolongement (7), du côté avant, qui forme la surface de sortie de lumière (8).

4. Elément d'affichage selon la revendication 3, **caractérisé en ce que** le prolongement est de forme cylindrique ou prismatique.

5. Elément d'affichage selon l'une des revendications 1 à 4, **caractérisé en ce que** la surface d'injection de lumière (2') est sensiblement disposée en face de la surface de sortie de lumière (8).

6. Elément d'affichage selon l'une des revendications 1 à 5, **caractérisé en ce que** la DEL (3) présente des fils de connexion (4) qui sont guidés, sous forme courbée, hors de l'évidement (2) logeant la DEL (3).

7. Elément d'affichage selon l'une des revendications 1 à 4, **caractérisé en ce que** la DEL (3) est une DEL diffusant la lumière du côté supérieur.

8. Elément d'affichage selon la revendication 7, **caractérisé en ce que** le conduit de lumière (1) présente une surface de réflexion (10) faisant face à la DEL (3) et au moins sensiblement oblique.

9. Elément d'affichage selon l'une des revendications 3, 4 ou 6 à 8, **caractérisé en ce que** le conduit de lumière (1) présente une courbure assurant la réflexion à partir de la surface d'injection de lumière (2') vers la surface de sortie de lumière (8).

10. Elément d'affichage selon l'une des revendications 3, 4 ou 6 à 8, **caractérisé en ce que** le conduit de lumière (1) présente sensiblement une forme de L et est au moins placé au-dessus d'un autre conduit de lumière (1), sensiblement en forme de parallélépipède rectangle.

11. Elément d'affichage selon l'une des revendications 1 à 5, **caractérisé en ce que** la DEL (3) est une DEL à rayonnement latéral, qui est disposée dans un creux (2) du conduit de lumière (1) qui est ouvert sur le fond et éventuellement à l'arrière.

12. Elément d'affichage selon l'une des revendications 1 à 9 ou 11, **caractérisé en ce que** le conduit de lumière (1) présente au moins deux surfaces de sortie de lumière (8) avec des DEL (3) affectées de façon correspondante.

13. Elément d'affichage selon l'une des revendications 1 à 12, **caractérisé en ce que** l'élément d'appui (9) peut être embroché dans la carte imprimée (5) et/ou placé sur celle-ci.

14. Elément d'affichage selon l'une des revendications 1 à 13, **caractérisé en ce que** au moins un élément d'appui (9) est constitué d'un seul tenant avec le conduit de lumière (1).

15. Elément d'affichage selon l'une des revendications 1 à 14, **caractérisé en ce qu'**il est prévu un obturateur (11) recouvrant le conduit de lumière (1).

16. Elément d'affichage selon la revendication 15, **caractérisé en ce que** l'obturateur (11) est constitué de façon à recouvrir en forme de peigne plusieurs conduits de lumière (1).

17. Elément d'affichage selon l'une des revendications 1 à 16, **caractérisé en ce que** le conduit dé lumière (1) est muni, au moins sur une surface délivrant de la lumière diffusée parasite, d'un revêtement imperméable à la lumière.

18. Elément d'affichage selon l'une des revendications 1 à 17, **caractérisé en ce que** le conduit de lumière (1) est teinté.
